Europäisches Patentamt

European Patent Office

Office européen des brevets

(11) Numéro de publication: **0 064 902**
**A1**

## (12) DEMANDE DE BREVET EUROPEEN

(21) Numéro de dépôt: **82400713.2**

(22) Date de dépôt: **21.04.82**

(51) Int. Cl.³: **H 03 H 17/04**

(30) Priorité: **07.05.81 FR 8109060**

(43) Date de publication de la demande:
**17.11.82 Bulletin 82/46**

(84) Etats contractants désignés:
**CH DE GB LI SE**

(71) Demandeur: **ENERTEC SOCIETE ANONYME**
**12, Place des Etats Unis**
**F-92120 Montrouge(FR)**

(72) Inventeur: **Loewenstein, Paul**
**1285 Montecito Avenue**
**Mountain View California 94043(US)**

(74) Mandataire: **Bentz, Jean-Paul**
**GIERS SCHLUMBERGER 12, Place Des Etats Unis**
**F-92124 Montrouge Cedex(FR)**

(54) **Filtres de décimation.**

(57) Les contributions, à chaque échantillon de sortie, des impulsions d'entrée (30 à 40) à tous les instants d'échantillonnage postérieurs à l'échantillon de sortie précédent, et de cet échantillon précédent lui-même, sont stockées dans une mémoire (62, 64, 66, 68). Lorsqu'un échantillon de sortie est délivré sa contribution à l'échantillon suivant est rangée dans un accumulateur (70) et une horloge (54, 58) est remise à zéro. Lorsqu'une impulsion d'entrée est reçue, sa contribution à l'échantillon de sortie suivant est extraite de la mémoire en fonction de l'indication de l'horloge, et rangée dans l'accumulateur, dont le contenu, à l'instant où l'échantillon de sortie suivant doit être produit, donne la valeur de cet échantillon.

Un tel filtre à décimation peut être utilisé pour effecteur une démodulation de fréquence.

FIG. 3

FILTRES DE DECIMATION

La présente invention concerne des filtres de décimation et plus précisément, bien que non exclusivement, des filtres de ce type conçus pour effectuer une démodulation de fréquence.

Les filtres de décimation (c'est à dire des filtres destinés à modifier la fréquence d'apparition d'un signal tel que des échantillons successifs provenant d'un convertisseur analogique-numérique) peuvent être utilisés dans diverses applications. On peut citer comme exemple la démodulation d'un signal impulsionnel modulé en fréquence (MF), c'est à dire un signal dont la fréquence de répétition à un instant donné est liée à la grandeur d'un paramètre à communiquer. Si le signal de sortie souhaité est sous forme analogique, ce traitement pose peu de problèmes ; cependant, si le signal de sortie souhaité est sous forme d'échantillons successifs codés numériquement, (dont la cadence n'est pas nécessairement liée à celle de l'échantillonnage effectué au cours du processus de modulation) on doit faire face à des exigences contradictoires si l'on utilise des filtres numériques classiques (dans lesquels le signal d'entrée est échantillonné à la cadence voulue et dans lesquels l'état final et le signal de sortie du filtre sont obtenus en fonction de ce signal d'entrée et de l'état ou des états antérieur(s) du filtre). En conséquence, bien qu'il soit nécessaire d'utiliser un taux d'échantillonnage nettement plus élevé que la fréquence maximale du signal d'entrée pour diminuer la distorsion au cas où le taux d'échantillonnage est peu différent d'un harmonique de la fréquence de modulation, la bande passante du filtre doit être suffisamment faible pour atténuer de façon efficace la fréquence de modulation elle-même. L'ensemble de ces exigences rend nécessaire l'utilisation d'un filtre ayant une très grande constante de temps ce qui exige le calcul et le stockage des états consécutifs du filtre avec une résolution élevée (au moyen d'un grand nombre de bits), cette opération étant difficile et onéreuse à réaliser en pratique. De plus, ce dispositif est très peu rentable et peu efficace dans le cas d'un démodulateur de fréquence étant donné qu'à de nombreux instants d'échantillonnage du signal d'entrée, aucun signal n'est présent.

La présente invention a pour but de fournir un filtre de décimation qui simplifie les problèmes mentionnés ci-dessus.

Selon l'un de ses aspects l'invention concerne un filtre de décimation caractérisé en ce qu'il comporte :

un dispositif conçu pour stocker des coefficients représentant tous deux l'effet sur les valeurs des variables d'état du filtre à un instant prédéterminé de sortie du signal, d'un signal d'entrée apparaissant à l'un des instants respectifs d'une série d'instants prédéterminés d'entrée du signal précédant ledit instant de sortie du signal, et pour stocker des facteurs représentatifs de l'effet sur ces valeurs à n'importe quel instant de sortie du signal, des valeurs correspondantes à l'instant de sortie du signal précédent ;

un dispositif conçu pour répondre à chaque signal d'entrée en incorporant parmi les valeurs des variables d'état concernant le prochain instant de sortie du signal, des valeurs reliées aux coefficients stockés et choisies en fonction de l'instant d'apparition de ce signal d'entrée ;

un dispositif conçu pour produire un signal de sortie sous forme d'une fonction linéaire de la valeur d'au moins une variable d'état à cet instant de sortie du signal ; et

un dispositif conçu pour incorporer aux valeurs des variables d'état concernant le prochain instant de sortie du signal, des valeurs reliées aux valeurs des variables d'état à l'instant de sortie du signal et également reliées aux facteurs stockés.

Avec un filtre de ce type, il est seulement nécessaire de stocker un ensemble de variables d'état du filtre, ainsi que les valeurs fixes précalculées des coefficients et des facteurs servant à la mise à jour et à l'itération de cet ensemble de variables en réponse à l'apparition des signaux d'entrée et à l'application de signaux de sortie, respectivement. En outre, il suffit que le processus de mise à jour mette en jeu une simple sélection et sommation du coefficient approprié avec la valeur à mettre à jour, permettant ainsi au filtre de fonctionner à vitesse élevée sans qu'il soit nécessaire d'utiliser des circuits arithmétiques rapides spéciaux.

On décrit ci-dessous à titre d'exemple un filtre de décimation conforme à la présente invention destiné à être utilisé comme démodulateur de fréquence numérique, en se référant aux dessins en annexe dans lesquels :

la fig. 1 illustre une forme d'onde et une représentation modulée en fréquence de celle-ci ;

la fig. 2 est un diagramme sous forme de blocs d'un filtre numérique généralisé ;

la fig. 3 est un diagramme sous forme de bloc du filtre de décimation ; et

la fig. 4 est un graphique représentant la séquence d'opérations effectuées dans une variante du filtre de la fig. 3.

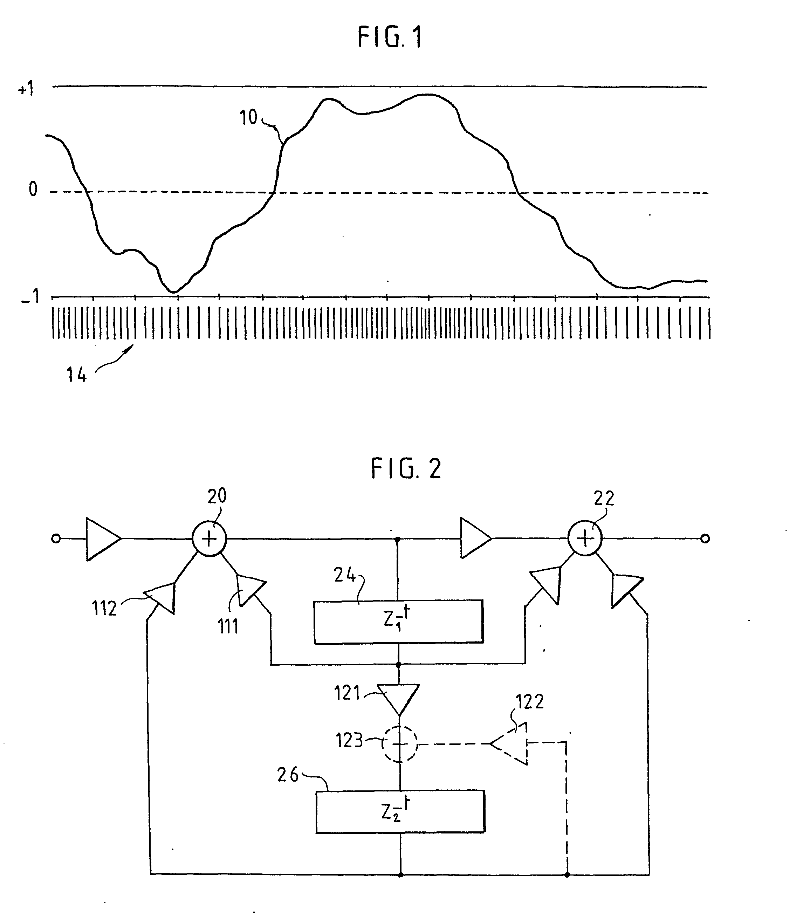

La fig. 1 représente une forme d'onde analogique 10. L'amplitude de cette forme d'onde entre les limites normalisées +1 et -1 détermine la fréquence de répétition (comprise entre 100 kHz et 50 kHz) obtenue en utilisant des techniques connues, d'un signal impulsionnel modulé en fréquence tel que celui représenté en 14. La récupération de la forme d'onde 10 à partir du signal MF 14 fait intervenir une démodulation de fréquence. Si l'on doit représenter la forme d'onde 10 à la sortie du processus de démodulation sous forme d'une suite d'échantillons codés numériquement de cette forme d'onde 10, on doit alors également accomplir d'une façon ou d'une autre une opération d'échantillonnage. Cependant les contraintes auxquelles est soumis cet échantillonnage, à savoir essentiellement un codage adéquat de la composante de fréquence la plus élevée de la forme d'onde 10, sont dans une certaine mesure indépendantes des contraintes auxquelles est soumis le processus de modulation au cours de l'échantillonnage notionnel, pour lequel on doit également tenir compte des exigences des processus de modulation et de transmission des signaux. Par conséquent, il est tout à fait possible que le taux d'échantillonnage utilisé dans le processus de démodulation/codage numérique, auquel peut s'appliquer la présente invention, soit très différent de la fréquence de modulation.

En théorie, il est possible d'utiliser un filtre numérique classique pour l'opération de démodulation/codage. Un filtre de ce type peut être représenté, comme le montre la fig. 2, par un étage de sommation d'entrée 20, un étage de sommation de sortie 22 et, à titre d'exemple, de deux registres de variables d'état, 24 et 26, qui stockent les valeurs des variables $z_1$ et $z_2$ représentant l'état de fonctionnement du filtre à un instant T antérieur à l'état courant. L'état courant du filtre, tel qu'il est produit à la sortie de l'étage de sommation d'entrée 20, est une fonction du signal d'entrée et des variables d'état antérieur $z_1^{-t}$ et $z_2^{-t}$. La sortie du filtre, telle qu'on l'obtient à la sortie de l'étage de sommation de sortie 22, est une fonction de l'état courant tel qu'il est fourni par l'étage de sommation d'entrée 20 et des mêmes variables d'état $z_1^{-t}$ et $z_2^{-t}$. L'état courant du filtre est appliqué aux registres 24 et 26 pour y être retenu en attendant la génération de l'état suivant et la sortie du filtre à un instant t ultérieur à l'état courant.

Chaque entrée de chacun des étages 20 et 22 et des registres 24 et 26 est précédée d'un multiplicateur correspondant. Les caractéristiques du filtre peuvent être sélectionnées par un choix approprié des constantes de multiplication des divers multiplicateurs.

On notera en particulier que les valeurs des variables d'état maintenues dans les registres 24 et 26 sont celles qui se produisent réellement du fait de la réception d'échantillons antérieurs du signal d'entrée se produisant réellement.

Cependant, l'utilisation d'un filtre numérique classique tel que celui représenté dans la fig. 2 pour démoduler et coder numériquement un signal impulsionnel MF présente des difficultés majeures. En particulier, le taux d'échantillonnage au niveau de l'étage d'entrée 20 du filtre doit être suffisamment élevé (de l'ordre de plusieurs dizaines de MHz) pour éviter une distorsion (en particulier les pics transitoires) apparaissant lorsque la cadence des impulsions variant de façon continue atteint une valeur ayant un harmonique très proche du taux d'échantillonnage de l'étage d'entrée 20. D'autre part, la bande passante du filtre doit être suffisamment faible pour assurer une réjection adéquate de la fréquence de répétition des impulsions elle-même (c'est à dire de la fréquence de la porteuse).

Les diverses contraintes exigent une très grande constante de temps qui se traduit au niveau de la conception pratique par une résolution très élevée (c'est à dire par un grand nombre de bits) de façon à réduire l'erreur de quantification, étant donné que l'intervalle entre deux échantillons d'entrée successifs du filtre est si court que les variables d'état ne peuvent varier que d'une très faible quantité devant être représentée avec précision, au cours d'un intervalle d'échantillonnage d'entrée donné. Même si les circuits arithmétiques rapides nécessaires étaient disponibles, ce procédé serait très coûteux et très peu efficace car on n'aura besoin d'un échantillon de sortie que très rarement par rapport au taux d'échantillonnage d'entrée -en général une fois tous les 10.000 échantillons d'entrée- et que pour la plupart des échantillons d'entrée, on aura en fait un niveau d'entrée zéro puisqu'aucune impulsion ne sera présente. Même lorsqu'une impulsion d'entrée est présente, elle a toujours, dans le cas d'un signal impulsionnel MF, la même amplitude prédéterminée.

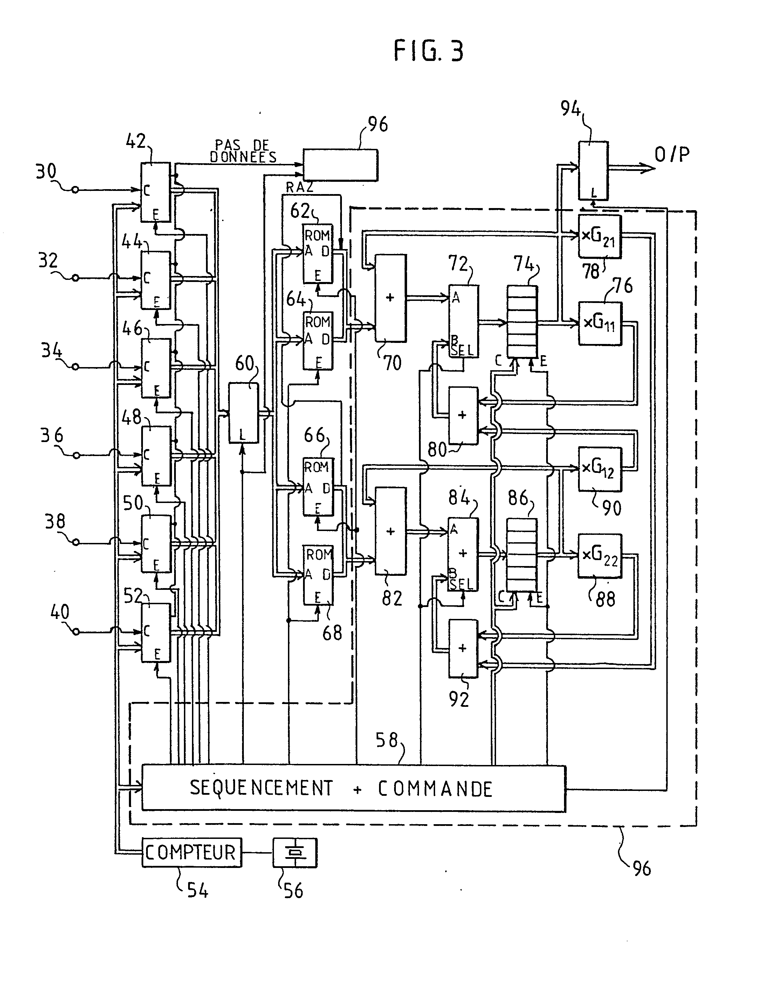

Le filtre de décimation représenté fig. 3 peut être utilisé pour réaliser le processus de démodulation/codage souhaité et évite ces problèmes. Le circuit particulier représenté dans la fig. 3 est destiné à l'utilisation dans les dispositifs de surveillance d'un réseau de transmission d'énergie triphasé et comporte par conséquent 6 entrées, c'est à dire une entrée pour la tension et pour le courant multiplexés dans un circuit de filtrage unique, et cela, pour chacune des phases.

Si l'on se rapporte à la fig. 3, ces 6 entrées 30, 32, 34, 36, 38 et 40 sont reliées aux bornes d'horloge C de six registres 42, 44, 46, 48, 50 et 52. Chacun de ces registres 42 à 52 reçoit un signal à 11 bits d'un compteur 54 commandé par des impulsions d'horloge provenant d'un oscillateur à cristal à 15 MHz 56. Une borne de validation de sortie E de chacun des registres 42 à 52 est reliée par l'intermédiaire d'un conducteur respectif à un circuit de séquencement et de commande 58.

Une sortie à 11 bits de chaque registre 42 à 52 est connectée en parallèle par l'intermédiaire d'un registre bloqueur à 11 bits 60, au bus d'adressage à 11 bits A de chacune des mémoires d'un groupe de quatre mémoires mortes (ROM) 62, 64, 66, et 68. Une borne de commande L du registre. bloqueur 60 est reliée au circuit de séquencement et de commande 58, et les bornes de validation de sortie E des ROM 62 à 68 sont également reliées au circuit 58 par paires 62 et 66, et 64 et 68.

Les bus de données à 16 bits D des deux ROM 62 et 64 sont connectés en parallèle à une entrée d'un circuit de sommation 70 dont la sortie est reliée à une entrée A d'un circuit sélecteur 72 ayant une entrée de commande de sélection SEL reliée au circuit de commande 58. La sortie du circuit sélecteur 72 est reliée à l'entrée d'un registre 74 à 6 mots qui comporte une commande de commutation de canaux C et une commande de validation de sortie E, toutes deux connectées au circuit 58. La sortie du registre 74 est reliée aux entrées de deux multiplicateurs 76 et 78 dont les facteurs de multiplication respectifs sont $G_{11}$ et $G_{21}$, et à la seconde entrée du circuit de sommation 70. La sortie du multiplicateur 76 est reliée à une entrée d'un circuit de sommation 80, dont la sortie est reliée à la seconde entrée B du circuit sélecteur 72.

0064902

- 9 -

Aux deux ROM 66 et 68, sont associés un circuit de sommation 82, un circuit de sélection 84, un registre 86, des multiplicateurs 88 et 90 (dont les facteurs de multiplication sont respectivement $G_{22}$ et $G_{12}$) et un circuit de sommation 92 correspondant à, et connecté de la même manière que les éléments 70 à 80. En outre, la sortie du multiplicateur 90 est connectée à la seconde entrée du circuit de sommation 80 et la sortie du multiplicateur 78 est également reliée au circuit de sommation 92.

Le signal de sortie du filtre est obtenu à la sortie du registre 74 par l'intermédiaire d'un registre bloqueur 94 ayant une borne de commande de débloquage L commandée par le circuit 58.

On stocke préalablement dans chacune des mémoires mortes 62 à 68 un ensemble de coefficients (à des adresses successives) représentant chacun l'effet (précalculé) qu'une impulsion d'entrée se produisant au début d'une série d'intervalles de temps de plus en plus courts antérieurs à l'instant généralisé où est produit un échantillon de sortie du filtre, aura à cet instant sur les valeurs des variables d'état $Z_1$ et $Z_2$. En particulier, les mémoires mortes 62 et 64 contiennent des coefficients concernant la variable d'état $Z_1$ et les mémoires mortes 66 et 68 contiennent des coefficients concernant la variable d'état $Z_2$. D'une manière pratiquement analogue, les facteurs de multiplication $G_{11}$ et $G_{21}$ représentent les effets que la valeur de la variable d'état $Z_1$, à n'importe quel instant où est produit un échantillon de sortie, aura à l'instant d'échantillonnage de sortie suivant sur les valeurs des variables d'état $z_1$ et $z_2$, respectivement ; de même, les facteurs $G_{12}$ et $G_{22}$ représentent les effets correspondants de la valeur de la variable d'état $z_2$. Par conséquent, les valeurs des facteurs de multiplication $G_{11}$ et $G_{21}$ sont équivalents aux constantes des multiplicateurs 111 et 121 (fig.2) reliés à la sortie du registre 24 ; et les valeurs de $G_{12}$ et $G_{22}$ sont équivalentes aux constantes du multiplicateur 112 et d'un multiplicateur supplémentaire 122 relié à la sortie du registre 26 (ce multiplicateur 122 produit un retour vers un étage de sommation supplémentaire 123 situé entre la sortie du registre 24 et l'entrée du registre 26 et est utilisé pour assurer une stabilité globale du filtre quelles que soient les caractéristiques des signaux d'entrée).

Il se peut que l'opération d'incorporation des facteurs $G_{11}$, $G_{21}$, $G_{12}$ et $G_{22}$ lorsqu'un échantillon de sortie a été produit, ne s'achève pas avant qu'une autre impulsion d'entrée soit reçue, au quel cas les coefficients normalement utilisés (après incorporation de ces facteurs) sont incorrects. Par conséquent, on dispose de deux ensembles de coefficients pour chaque variable d'état : un ensemble (pour $z_1$, dans la ROM 62 et pour $z_2$, dans la ROM 66) destiné à être utilisé avant que les facteurs $G_{11}$, $G_{21}$, $G_{12}$ et $G_{22}$ aient été incorporés ; et un second ensemble (dans les ROM 64 et 68) destiné à être utilisé après que ces facteurs aient été incorporés.

Les anciennes valeurs $Z_1$, $Z_2$, les nouvelles valeurs $Z'_1$, $Z'_2$ et les facteurs $G_{11}$, $G_{21}$, $G_{12}$ et $G_{22}$ sont liés par l'équation matricielle de transition :

$$
\begin{bmatrix} Z_1' \\ \\ Z_2' \end{bmatrix}
=
\begin{bmatrix} G_{11} & G_{12} \\ \\ G_{21} & G_{22} \end{bmatrix}
\begin{bmatrix} Z_1 \\ \\ Z_2 \end{bmatrix}
\tag{1}
$$

d'où l'on tire :

$$Z'_1 = G_{11}Z_1 + G_{12}Z_2$$

$$Z'_2 = G_{21}Z_1 + G_{22}Z_2$$

Les valeurs des facteurs $G_{11}$, $G_{21}$, $G_{12}$ et $G_{22}$ peuvent par exemple être calculées à partir d'une expression de la forme :

$$
e^{\propto T}
\begin{bmatrix} \cos\beta T & \sin\beta T \\ \\ -\sin\beta T & \cos\beta T \end{bmatrix}
\tag{2}
$$

où $\propto$ et $\beta$ sont des constantes dépendant de la caractéristique du filtre souhaitée et T est l'intervalle séparant les instants d'échantillonnage, de sortie. On peut faire varier la forme exacte de cette expression pour obtenir les caractéristiques du filtre particulières souhaitées.

Avec ces valeurs de $\alpha$ et $\beta$ , les coefficients stockés dans les mémoires mortes 62 et 68 peuvent être calculés à partir des expressions :

$$k\, e^{\frac{\alpha(T-t)}{T}} \quad \cos\beta\, \frac{T-t}{T} \qquad (3)$$

$$k\, e^{\frac{\alpha(T-t)}{T}} \quad \sin\beta\, \frac{T-t}{T} \qquad (4)$$

où t est le temps s'étant écoulé depuis le dernier échantillon de sortie.

Dans la pratique, pour une matrice de transition donnée, on peut par exemple trouver $\alpha$ et $\beta$ en les exprimant respectivement sous forme des parties réelle et imaginaire des logarithmes des valeurs propres (c'est à dire les solutions de l'équation caractéristique) de la matrice de transition. Au cas où la matrice de transition a par exemple des valeurs propres réelles pures, on peut modifier l'analyse de façon appropriée conformément à des principes connus.

Dans un mode de réalisation pratique, destiné à démoduler un signal MF compris entre 50 kHz et 100 kHz, des coefficients ont été calculés pour des instants d'arrivée successifs possibles des impulsions séparés de 1/15 microseconde, les échantillons de sortie du filtre étant pris toutes les 136 microsecondes.

Par conséquent, deux ensembles de 2048 coefficients ont été stockés respectivement dans les mémoires mortes 64 et 68. En outre, deux autres ensembles de seulement 1024 coefficients ont été calculés à partir des expressions (3) et (4), la variable T du numérateur étant prise égale à 0, et ont été stockés dans les mémoires mortes 62 et 66, afin d'être utilisés, comme on l'a expliqué ci-dessus, avant d'acquérir les facteurs $G_{11}$, $G_{21}$, $G_{12}$ et $G_{22}$ (comme cela ne devrait demander qu'environ 60 microsecondes, ces coefficients ne sont nécessaires que pendant la première moitié de l'intervalle séparant les échantillons de sortie).

On a trouvé que ces facteurs avaient les valeurs suivantes :

$$G_{11} = 0,75 \qquad G_{12} = 0,25$$

$$G_{21} = - 0,25 \qquad G_{22} = 0,75$$

ceux-ci étant calculés à partir de l'expression (2) donnée plus haut.

Les valeurs propres correspondantes sont :

$$\frac{3}{4} + \frac{j}{4} \quad \text{et} \quad \frac{3}{4} - \frac{j}{4}$$

Le logarithme de leur module,

$$\ln \sqrt{(\tfrac{3}{4})^2 + (\tfrac{1}{4})^2} = - 0,2350018$$

est la valeur de $\propto$ correspondante, et l'arctangente en radians de leur rapport:

$$\text{arctg} \ (\tfrac{1}{4}) \ / \ (\tfrac{3}{4}) = 0,3217506$$

est la valeur correspondante de ß.

En cours de fonctionnement, l'oscillateur 56 fournit des impulsions à 15 MHz au compteur 54, qui est prévu pour être remis à zéro au bout de 2048 impulsions (136 microsecondes). Le total contenu dans le compteur 54 est envoyé en continu vers chacun des registres 42 à 52, et celui-ci fournit le total courant à l'instant où il reçoit sur sa borne d'horloge C une impulsion du signal impulsionnel MF provenant des entrées respectives 30 à 40. Ainsi, le total contenu à cet instant dans le registre indique le temps qui s'est écoulé, à l'instant d'arrivée de l'impulsion, depuis l'instant où le compteur a été remis à zéro pour la dernière fois, et, de façon complémentaire, le temps devant s'écouler jusqu'à la prochaine remise à zéro de ce compteur, (c'est à dire le prochain instant d'échantillonnage de sortie). Ce temps dépend de l'intervalle séparant les impulsions et par conséquent, de la fréquence de répétition des impulsions instantanées.

Les contenus de chacun des registres 42 à 52 sont cycliquement explorés par le circuit de séquencement et de commande 58, par l'intermédiaire de sa borne de validation de sortie respective E, à une cadence supérieure à la fréquence maximale de répétition des impulsions au niveau des entrées 30 à 40 (dans ce cas, 100 kHz). Simultanément, la borne de commande de déblocage L du registre bloqueur 60 est validée de façon que les contenus des registres 42 à 52 soient à leur tour transférés dans le registre bloqueur 60 et ainsi, appliqués sur les bus d'adressage A des mémoires mortes 62 à 68. Après un court temps de stabilisation, les bornes de validation de sortie E de l'une ou l'autre des paires de mémoires mortes 62 et 66 ou 64 et 68 sont activées ; si les facteurs $G_{11}$, $G_{21}$, $G_{12}$ et $G_{22}$ n'ont pas été incorporés depuis l'instant d'échantillonnage de sortie le plus récent, les mémoires mortes 62 et 66 sont sélectionnées ; dans le cas contraire, les mémoires mortes 64 et 68 sont sélectionnées.

Il en résulte que chacune des paires de mémoires mortes validées envoie sur son bus de données D la valeur du ceofficient stocké à la position identifiée par la valeur du total appliqué à son bus d'adressage A par le registre bloqueur 60. En conséquence, le coefficient fourni est sélectionné selon l'instant d'apparition, par rapport à l'instant d'échantillonnage de sortie suivant, de l'impulsion d'entrée qui a initialement provoqué le bloquage de ce total dans l'un des registres 42 à 52 ; et la valeur de ce coefficient indique l'effet qu'une impulsion d'entrée se produisant à cet instant aurait sur la valeur de sortie du filtre à l'instant où l'on obtient l'échantillon de sortie suivant.

Il se peut dans certains cas qu'il n'y ait aucune impulsion d'entrée entre les explorations successives d'un registre d'entrée 42 à 52. Pour remédier à ce problème, chacun des registres 42 à 52 est conçu pour fournir une indication à un registre bloqueur 96 qu'aucune donnée n'y a été stockée et ce registre bloqueur impose alors aux données des bus de données D, la valeur zéro.

La valeur du coefficient sur le bus de données D de la mémoire morte 62/64 est envoyée au circuit de sommation 70.

Simultanément, le circuit de séquencement et de commande 58 active la commande de validation de sortie E du registre 74 à 6 mots après avoir préalablement appliqué un signal sur la commande de commutation de canaux C pour identifier le mot dans le registre 74 correspondant à celui des registres 42 à 52 qui a fourni le total se trouvant alors dans le registre bloqueur 60, (et commandant ainsi la sélection du coefficient sur le bus de données D). Ce mot, qui est la variable d'état $Z_1$ du filtre pour l'entrée correspondante 30 à 40, apparait ainsi comme étant le signal de sortie du registre 74 et est également fourni au circuit de sommation 70. Ce circuit remet à jour la valeur de $Z_1$ en y additionnant la valeur du coefficient se trouvant sur le bus de données D, et la valeur remise à jour est de nouveau stockée, par l'intermédiaire du circuit sélecteur 72 (normalement commandé pour sélectionner son entrée A) dans le registre 74.

Simultanément, le mot correspondant dans le registre 86 représentant la variable d'état $Z_2$, est remise à jour de façon à incorporer la valeur du coefficient se trouvant sur le bus de données D de celle des mémoires mortes 66 et 68 qui a été sélectionnée, au moyen du circuit de sommation 82 et du circuit sélecteur 84.

Le registre 42 à 52 suivant est ensuite validé de façon à charger le registre bloqueur 60 et l'opération de remise à jour est répétée pour les mots correspondants dans les registres 74 et 86. On notera que ces opérations mettent essentiellement en jeu le transfert de données, l'adressage de mémoires mortes, et une simple sommation, toutes ces opérations pouvant être facilement effectuées à vitesse très élevée ; par conséquent, ce circuit peut non seulement fonctionner suffisamment rapidement pour fournir un signal de sortie utilisable, mais peut même être multilplexé avec plusieurs entrées, comme le montre la fig. 3.

L'exploration cyclique des registres 42 à 52 et la remise à jour des mots des variables d'état correspondants dans les registres 74 et 86 se poursuivent jusqu'à ce que le compteur 54 se remette à zéro au bout de 2048 impulsions provenant de l'horloge 56. Cet état est détecté par le circuit de séquencement et de commande 58, qui procède alors à l'envoi d'un échantillon de sortie et à l'itération destinée à incorporer les facteurs $G_{11}$, $G_{21}$, $G_{12}$ et $G_{22}$. A cet effet, le circuit 58 active tout d'abord de façon répétée l'entrée de commande de déblocage L du registre bloqueur 94, à l'instant où le registre 74 délivre son contenu en vue de la remise à jour de chacun des 6 mots qui y sont stockés. Ainsi, chacun de ces 6 mots est également obtenu successivement en sortie par l'intermédiaire du registre bloqueur 94. Un choix approprié des équations des variables d'état du filtre permet de traiter directement ces mots (représentant la variable d'état $Z_1$, pour chacun des 6 signaux d'entrée) comme signaux de sortie du filtre.

Après quoi, au fur et à mesure que les registres 74 et 86 fournissent chacun des six mots qu'ils contiennent, le circuit 58 actionne l'entrée de commande de sélection SEL des circuits sélecteurs 72 et 84 de façon à sélectionner leurs entrées B.

En conséquence, dans chaque paire correspondante de valeurs $Z_1$ et $Z_2$, $Z_1$ est multiplié par $G_{11}$ dans le multiplicateur 76 et par $G_{21}$ dans le multiplicateur 78, les produits étant respectivement fournis aux circuits de sommation 80 et 92 ; et $Z_2$ est multiplié par $G_{22}$ dans le multiplicateur 88 et par $G_{12}$ dans le multiplicateur 90, les produits étant fournis respectivement aux circuits de sommation 92 et 80. Le circuit de sommation 80 additionne $G_{11}Z_1$ à $G_{12}Z_2$ ce qui donne une nouvelle valeur de $Z_1$ qui est ensuite chargée, par l'intermédiaire de l'entrée B du circuit sélecteur 72 sélectionnée à cet instant, dans la zone appropriée du registre 74. De même, le circuit de sommation 92 additionne $G_{21}Z_1$ à $G_{22}Z_2$, ce qui donne une nouvelle valeur de $Z_2$ qui est chargée, par l'intermédiaire du circuit sélecteur 84, dans le registre 86.

Jusqu'à ce que cette opération d'itération soit achevée, pour une paire quelconque de mots contenus dans les registres 74 et 86, la remise à jour de ces mots en réponse à d'autres impulsions d'entrée se poursuit de la façon décrite ci-dessus, en utilisant les mémoires mortes 62 et 66. Une fois que l'itération de chaque paire de mots est achevée, une nouvelle mise à jour de cette paire de mots est effectuée en utilisant les coefficients stockés dans les mémoires mortes 64 et 68. Le degré d'utilisation des mémoires 62 et 68, ou même la nécessité d'utiliser ces mémoires, dépend de la vitesse de fonctionnement des circuits d'itération par rapport à la vitesse à laquelle s'effectue la remise à jour régulière.

On notera qu'il n'est nécessaire d'effectuer le processus d'itération que lorsqu'un échantillon de sortie a été fourni . En outre, les valeurs stockées dans les mémoires mortes 62 à 68 sont celles des coefficients fixes et sont prédéterminées, quel que soit le signal d'entrée effectivement appliqué, dont le seul rôle est de déterminer la sélection des coefficients à combiner de façon à former le signal de sortie voulu pour l'instant d'échantillonnage de sortie souhaité. Cela est à opposer au filtre numérique classique dans lequel les valeurs stockées sont celles des états successifs réels du filtre et dépendent complètement de la forme du signal d'entrée que l'on applique à un instant donné, et qui met en jeu un grand nombre de calculs complexes et longs.

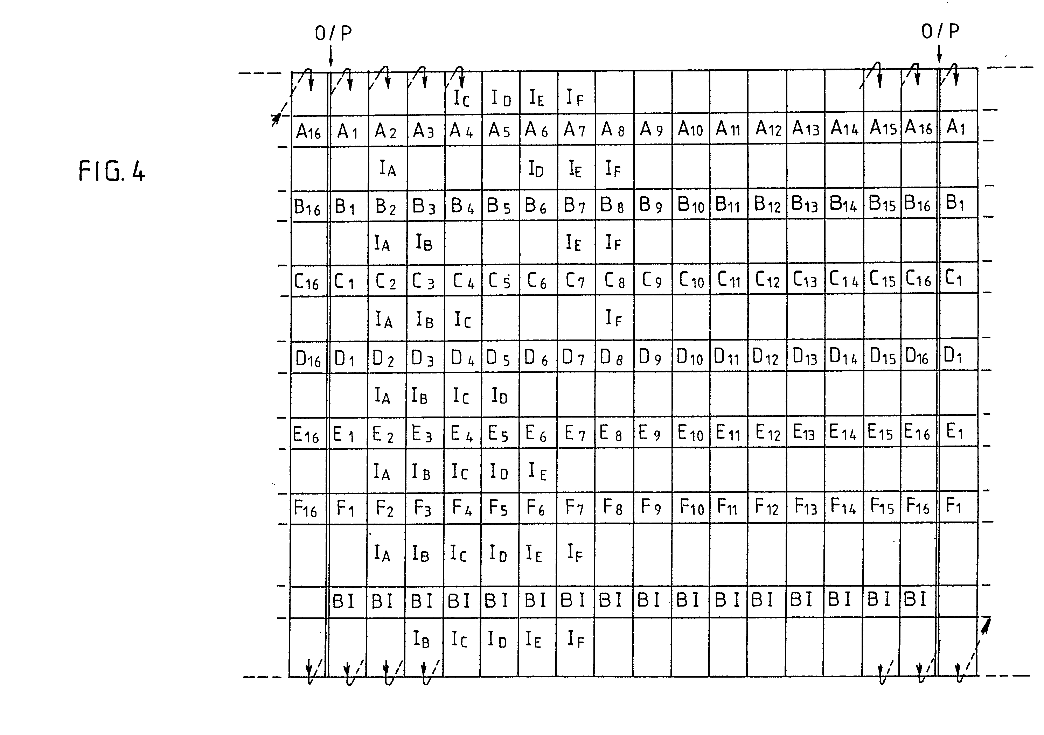

Les fonctions des circuits entourés par la ligne pointillée 96 de la fig. 3 peuvent être, si on le souhaite, réalisées par des circuits intégrés tels que l'unité arithmétique et logique/registre à 4 bits AM 290I, dont 4 seraient nécessaires dans ce cas (un par groupe de 4 bits de chacun des signaux de données à I6 bits provenant des mémoires mortes 62 à 68). La durée du cycle d'un dispositif de ce type est telle qu'au moins 512 instructions peuvent être exécutées au cours des I36 microsecondes séparant les échantillons de sortie. Ces instructions peuvent être séquencées de la façon illustrée dans la fig. 4.

Si l'on se réfère à la fig. 4, la séquence d'instructions est divisée notionnellement en 16 blocs de 32 instructions, chacun d'entre eux étant compris entre deux instants successifs où sont produits des échantillons de sortie O/P. A l'intérieur de chacun des blocs, on compte six ensembles de séquences d'instructions A à F (les suffixes correspondant aux divers blocs de la fig. 4) consacrées à la mise à jour des variables d'état correspondant à chacune des entrées 30 à 40, respectivement. En conséquence, chaque variable d'état est remise à jour 16 fois sur 136 microsecondes, c'est à dire à une fréquence d'environ 118 kHz, cette fréquence étant supérieure à la fréquence maximale de répétition des impulsions d'entrée (100 kHz) comme on l'a indiqué plus haut. Entre chacune des séquences A à F, on trouve des parties successives d'ensembles de séquences d'instructions $I_A$, $I_B$, etc., qui concernent l'itération des variables d'état servant à acquérir les facteurs $G_{11}$, $G_{21}$, $G_{12}$ et $G_{22}$.

Comme on l'a indiqué dans la fig. 4, ces séquences d'instructions d'itération sont considérablement plus longues que les séquences d'instructions de mise à jour, car elles font intervenir des processus de multiplication et non les simples additions beaucoup plus rapides utilisées pour la mise à jour. D'une manière générale, l'itération de l'ensemble des six paires de variables d'état peut demander la moitié de l'intervalle séparant deux échantillons de sortie successifs. Comme on l'a expliqué ci-dessus, des coefficients de mise à jour différents sont nécessaires avant et après l'itération. Par conséquent, dans l'exemple représenté dans la fig. 4, la séquence de mise à jour $A_1$ ferait intervenir des coefficients dans les mémoires mortes 62 et 66, avant que les séquences d'itération $I_A$ n'aient lieu, et les séquences $A_2$ à $A_{16}$ qui suivent l'itération feraient intervenir des coefficients dans les mémoires 64 et 68. De même, les séquences de mise à jour $F_1$ à $F_6$ utiliseraient des coefficients se trouvant dans les mémoires mortes 62 et 66, et les séquences $F_7$ à $F_{16}$ utiliseraient les coefficients se trouvant dans les mémoires mortes 64 et 68. En plus des séquences d'instructions de mise à jour et d'itération, une courte séquence BI est utilisée vers la fin de chaque bloc de 32 instructions pour permettre d'introduire un biais dans le signal de sortie afin de compenser le décalage de niveau provoqué par la modulation de fréquence.

Bien que le filtre de décimation de l'invention ait été décrit dans le contexte d'une démodulation mf à sortie échantillonnée, on notera que son utilisation peut être étendue à d'autres situations où un filtrage de décimation est nécessaire.

## REVENDICATIONS

1 - Filtre de décimation caractérisé en ce qu'il comporte un dispositif conçu pour stocker des coefficients représentant chacun l'effet sur les valeurs de variables d'état du filtre à un instant prédéterminé de sortie du signal, d'un signal d'entrée se produisant à l'un des instants respectifs successifs prédéterminés d'entrée du signal, antérieur audit instant de sortie du signal, et pour stocker des facteurs représentatifs de l'effet sur ces valeurs, à n'importe quel instant de sortie du signal, des valeurs correspondantes à l'instant de sortie du signal précédent,

un dispositif conçu pour répondre à chaque signal d'entrée en incorporant des valeurs reliées aux coefficients stockés sélectionnés en fonction de l'instant d'apparition de ce signal d'entrée, parmi les valeurs des variables d'état concernant le prochain instant de sortie du signal ;

un dispositif conçu pour produire un signal de sortie ayant la forme d'une fonction linéaire de la valeur d'au moins une variable d'état à cet instant de sortie du signal ; et

un dispositif conçu pour incorporer des valeurs reliées aux valeurs des variables d'état à cet instant de sortie du signal et également reliées aux facteurs stockés, aux valeurs des variables d'état concernant l'instant de sortie du signal suivant.

2 - Filtre de décimation selon la revendication 1, caractérisé en ce que la valeur incorporée à la valeur d'une variable d'état en réponse à chacun des signaux d'entrée, est proportionnelle au coefficient sélectionné.

3 - Filtre de décimation selon la revendication 2, caractérisé en ce que la valeur incorporée est égale au coefficient sélectionné.

4 - Filtre de décimation selon l'une quelconque des revendications précédentes, caractérisé en ce que ledit signal de sortie est égal à la valeur de ladite variable d'état.

5 - Filtre de décimation selon l'une quelconque des revendication précédentes, caractérisé en ce que lesdits coefficients et facteurs sont obtenus à partir de fonctions sinusoïdales à décroissance exponentielle.

6 - Application du filtre selon l'une quelconque des revendications précédentes, à une démodulation de fréquence à sortie échantillonnée.

FIG. 1

FIG. 2

# FIG. 3

PAS DE DONNÉES

RAZ

O/P

SEQUENCEMENT + COMMANDE

COMPTEUR

FIG. 4

| | | | | | | | | | | | | | | | | | |
|---|---|---|---|---|---|---|---|---|---|---|---|---|---|---|---|---|---|
| | | | | $I_C$ | $I_D$ | $I_E$ | $I_F$ | | | | | | | | | | |
| $A_{16}$ | $A_1$ | $A_2$ | $A_3$ | $A_4$ | $A_5$ | $A_6$ | $A_7$ | $A_8$ | $A_9$ | $A_{10}$ | $A_{11}$ | $A_{12}$ | $A_{13}$ | $A_{14}$ | $A_{15}$ | $A_{16}$ | $A_1$ |
| | | $I_A$ | | | $I_D$ | $I_E$ | $I_F$ | | | | | | | | | | |
| $B_{16}$ | $B_1$ | $B_2$ | $B_3$ | $B_4$ | $B_5$ | $B_6$ | $B_7$ | $B_8$ | $B_9$ | $B_{10}$ | $B_{11}$ | $B_{12}$ | $B_{13}$ | $B_{14}$ | $B_{15}$ | $B_{16}$ | $B_1$ |
| | | $I_A$ | $I_B$ | | | $I_E$ | $I_F$ | | | | | | | | | | |
| $C_{16}$ | $C_1$ | $C_2$ | $C_3$ | $C_4$ | $C_5$ | $C_6$ | $C_7$ | $C_8$ | $C_9$ | $C_{10}$ | $C_{11}$ | $C_{12}$ | $C_{13}$ | $C_{14}$ | $C_{15}$ | $C_{16}$ | $C_1$ |
| | | $I_A$ | $I_B$ | $I_C$ | | | $I_F$ | | | | | | | | | | |
| $D_{16}$ | $D_1$ | $D_2$ | $D_3$ | $D_4$ | $D_5$ | $D_6$ | $D_7$ | $D_8$ | $D_9$ | $D_{10}$ | $D_{11}$ | $D_{12}$ | $D_{13}$ | $D_{14}$ | $D_{15}$ | $D_{16}$ | $D_1$ |
| | | $I_A$ | $I_B$ | $I_C$ | $I_D$ | | | | | | | | | | | | |
| $E_{16}$ | $E_1$ | $E_2$ | $E_3$ | $E_4$ | $E_5$ | $E_6$ | $E_7$ | $E_8$ | $E_9$ | $E_{10}$ | $E_{11}$ | $E_{12}$ | $E_{13}$ | $E_{14}$ | $E_{15}$ | $E_{16}$ | $E_1$ |
| | | $I_A$ | $I_B$ | $I_C$ | $I_D$ | $I_E$ | | | | | | | | | | | |
| $F_{16}$ | $F_1$ | $F_2$ | $F_3$ | $F_4$ | $F_5$ | $F_6$ | $F_7$ | $F_8$ | $F_9$ | $F_{10}$ | $F_{11}$ | $F_{12}$ | $F_{13}$ | $F_{14}$ | $F_{15}$ | $F_{16}$ | $F_1$ |
| | | $I_A$ | $I_B$ | $I_C$ | $I_D$ | $I_E$ | $I_F$ | | | | | | | | | | |
| | BI | BI | BI | BI | BI | BI | BI | BI | BI | BI | BI | BI | BI | BI | BI | BI | |
| | | | $I_B$ | $I_C$ | $I_D$ | $I_E$ | $I_F$ | | | | | | | | | | |

0064902

**Office européen des brevets**

## RAPPORT DE RECHERCHE EUROPEENNE

Numéro de la demande

EP 82 40 0713

### DOCUMENTS CONSIDERES COMME PERTINENTS

| Categorie | Citation du document avec indication, en cas de besoin, des parties pertinentes | Revendication concernee | CLASSEMENT DE LA DEMANDE (Int. Cl. ³) |
|---|---|---|---|
| A | PROCEEDINGS OF THE NATIONAL ELEC-TRONICS CONFERENCE, vol. 25, 8-10 décembre 1969, OAK BROOKS (US) A.D. SYPHERD: "Design of digital filters using read-only memories", pages 691-693. <br><br> * en entier * | 1 | H 03 H 17/04 |
| A | IEEE TRANSACTIONS ON ACOUSTICS, SPEECH AND SIGNAL PROCESSING, vol. ASSP-22, no. 6, décembre 1974, IEEE, NEW YORK (US) A. PELED: "A New Hardware Realiza-tion of Digital Filters", pages 456-462. <br><br> * en entier * | 1 | |

**DOMAINES TECHNIQUES RECHERCHES (Int. Cl. ³)**

H 03 H

Le present rapport de recherche a ete etabli pour toutes les revendications

| Lieu de la recherche | Date d achevement de la recherche | Examinateur |
|---|---|---|
| LA HAYE | 14-07-1982 | DECONINCK |